# FASCICULE DE BREVET EUROPEEN

(11) **EP 0 799 558 B1**
(45) Date de publication et mention de la délivrance du brevet: **14.03.2001**
(21) Numéro de dépôt: 96934933.1
(22) Date de dépôt: 18.10.1996
(51) Int. Cl.: H05K 3/28, B05D 1/34

(54) **PROCEDE POUR DEPOSER UN REVETEMENT DE PROTECTION SUR LES COMPOSANTS D'UNE CARTE ELECTRONIQUE**
VERFAHREN ZUM AUFTRAGEN EINER SCHUTZBESCHICHTUNG AUF DIE BAUTEILE EINER LEITERPLATTE
METHOD FOR DEPOSITING A PROTECTIVE COATING ON THE COMPONENTS OF AN ELECTRONIC BOARD

(30) Priorité: 25.10.1995 FR 9512595
(43) Date de publication de la demande: 08.10.1997
(73) Titulaire: GIAT INDUSTRIES, 78000 Versailles (FR)
(72) Inventeur: DESSAUX, Christophe, F-82130 Lafrançaise (FR); MOREAU, Emmanuel, F-31400 Toulouse (FR)
(74) Mandataire: Célanie, Christian
(86) Numéro de dépôt international: FR9601630
(87) Numéro de publication internationale: WO9716055

(56) Documents cités:
- WO-A-95/15579
- US-A- 5 330 101
- ELECTRONIC PACKAGING AND PRODUCTION, vol. 30, no. 4, Avril 1990, MASSACHUSETTS US, pages 39-40, XP000117358 ENGINEER'S FACT FILE: "Conformal coating materials"
- PATENT ABSTRACTS OF JAPAN vol. 13, no. 394 (C-631), 31 Août 1989 & JP,A,01 138220 (SUMITOMO BAKELITE CO), 31 Mai 1989,
- PATENT ABSTRACTS OF JAPAN vol. 17, no. 241 (E-1364), 14 Mai 1993 & JP,A,04 365394 (MATSUSHITA ELECTRIC IND CO), 17 Décembre 1992,

## Description

La présente invention concerne un procédé pour déposer un revêtement de protection sur les composants d'une carte électronique, le revêtement étant constitué par un matériau polymérisable tel qu'une résine.

Il est connu de protéger les composants des cartes électroniques utilisées dans un environnement hostile (température, humidité, chocs, vibrations, ...), en les enrobant d'un revêtement constitué d'une résine polymérique. Une telle opération est souvent dénommée « vernissage » ou « tropicalisation » des cartes.

D'une manière générale, un revêtement de protection est constitué d'une seule couche de résine déposée par aspersion, pulvérisation ou trempage de la carte dans un bain liquide de la résine.

Cependant, la protection obtenue au moyen de cette couche de résine s'avère bien souvent insuffisante. En effet, la complexité des cartes électroniques due à la présence de composants actifs et/ou passifs de taille et de fragilité aussi diverses que des connecteurs, les différents boîtiers des composants électroniques ou à circuits intégrés, etc... nécessite une protection par enrobage différente suivant le type de composant considéré. Pour cela, il est nécessaire de réaliser des moules différents et des résines de nature différente pour enrober sélectivement chaque type de composant de la carte avec un revêtement approprié (voir, par exemple, US-A-5 330 101). Concrètement, les connecteurs nécessitent un enrobage à base d'une résine visqueuse pour résister notamment aux chocs, alors que les composants en boîtier CMS (Composants Montés en Surface) nécessitent une protection contre l'humidité par exemple, au moyen d'une résine soit très fluide pour des boîtiers de petite taille, soit semi-visqueuse pour des boîtiers plus importants. Il en résulte que la protection des différents composants d'une même carte électronique nécessite, pour chaque type de composant, la réalisation d'un moulé de rétention de la résine afin qu'elle soit déposée de manière sélective sans couler au-delà du composant que l'on cherche à protéger.

Dans ces conditions, la protection des composants d'une carte électronique nécessite la fabrication préalable de plusieurs moules et une opération d'enrobage pour chaque moule utilisé. Il en résulte une mise en oeuvre longue et complexe, qui aboutit à des coûts de fabrication très élevés.

Le but de l'invention est de pallier ces inconvénients et, à cet effet, l'invention propose un procédé pour déposer un revêtement de protection sur les composants d'une carte électronique, qui est caractérisé en ce qu'il consiste à préparer le matériau constituant le revêtement à partir d'un mélange initial d'au moins deux constituants, et à ajouter à ce mélange initial au moins un troisième constituant en quantité variable de manière à faire varier la viscosité du mélange initial suivant le type de composant à protéger pendant l'opération d'enrobage des composants de la carte électronique.

Selon une autre caractéristique du procédé selon une modification de l'invention, les deux constituants du mélange initial sont respectivement formés par un isocyanate et un polyol, ces deux constituants réagissant ensemble pour former une résine.

Selon une autre caractéristique d'une modofication de l'invention, le troisième constituant qui permet de faire varier la viscosité du mélange initial est formé par un agent thyxotropant ou par un catalyseur.

D'une manière générale, le procédé selon une autre modification de l'invention consiste à réaliser le mélange initial à l'intérieur d'une unité de mélange équipée d'une buse d'éjection et, selon une autre caractéristique du procédé, le troisième constituant est avantageusement ajouté au mélange initial dans une chambre de sortie de l'unité qui est en communication avec la buse d'éjection, le revêtement de protection étant ensuite éjecté de la buse pour être déposé d'une manière sélective sur les différents composants suivant la viscosité requise pour chaque type de composant de la carte, en déplaçant la buse par rapport à la carte ou inversement.

Selon un avantage important de l'invention, il est possible d'enrober les composants d'une carte électronique par un revêtement de protection constitué à partir d'un même mélange initial dont on peut faire varier la viscosité suivant le type de composant à protéger, en n'utilisant qu'un seul appareillage qui, en une seule opération ou passe, est capable d'enrober tous les composants à protéger qui sont en saillie sur au moins une face de la carte électronique.

Selon un autre avantage de l'invention, i l'appareillage nécessaire à la mise en oeuvre du procédé peut être conçu de manière totalement indépendante des spécificités propres à chaque carte électronique, en particulier des dimensions de la carte et du nombre de composants qu'elle supporte.

Selon encore un autre avantage de l'invention, l'appareillage nécessaire à la mise en oeuvre du procédé est d'un coût considérablement réduit par rapport à ceux utilisés dans la technique antérieure.

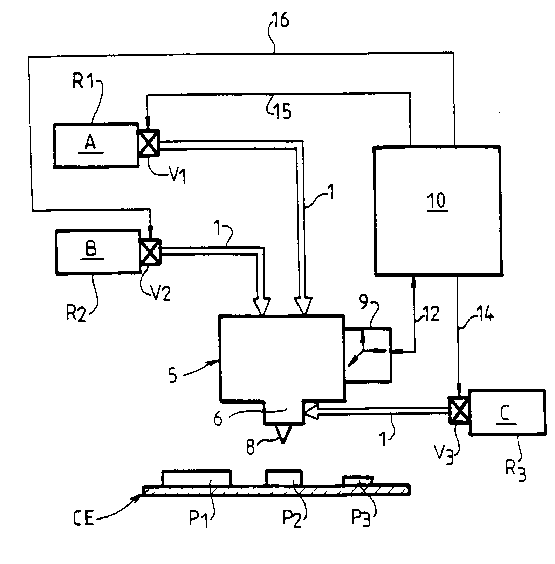

D'autres avantages, caractéristiques et détails de modifications de l'invention ressortiront de la description explicative qui va suivre, faite en référence au dessin annexé qui illustre schématiquement le principe du procédé selon l'invention.

La protection des composants d'une carte électronique envisagée selon l'invention consiste à déposer au moins sur chacun des composants un revêtement formé à partir d'un mélange initial d'au moins deux constituants pour obtenir un matériau polymérisable tel qu'une résine.

Ce mélange initial est formé à partir d'un premier constituant A tel qu'un isocyanate et par un second constituant B tel qu'un polyol. Ces deux constituants A et B réagissent l'un avec l'autre pour former une résine ayant une certaine viscosité. A titre d'exemple, l'isocyanate utilisé est du type toluène diisocyanate ou du type diphénylméthanediisocyanate-4,4', et le polyol utilisé est du type polyéther-polyol ou du type polyester-polyol.

A ce mélange initial, on ajoute au moins un troisième constituant C destiné à faire varier la viscosité du mélange initial, ce troisième constituant étant un agent thyxotropant ou un catalyseur. A titre d'exemple, l'agent thyxotropant utilisé est une 2,4 bis (p-aminobenzyl) aniline, et le catalyseur utilisé est un composé organométallique tel qu'un dilaurate de dibutylétain.

Concrètement, en se reportant au dessin annexé, les deux constituants A et B du mélange initial et le troisième constituant C destiné à faire varier la viscosité de ce mélange initial, sont stockés dans trois réservoirs R1, R2 et R3, respectivement.

Les deux réservoirs R1 et R2 sont reliés par un conduit 1 à une unité de mélange 5 pour y être mélangés. L'unité de mélange 5 comporte avantageusement une chambre de sortie 6 qui est en communication avec une buse d'éjection 8. Le troisième réservoir R3 est relié par un conduit 1 à la chambre de sortie 6 de l'unité de mélange 5 pour faire varier la viscosité du mélange initial juste avant son éjection au travers de la buse 8. L'unité de mélange 5 est par exemple mobile suivant trois directions de manière à pouvoir se déplacer par rapport à la carte électronique CE qui reste fixe. Les moyens qui assurent les déplacements de l'unité de mélange 5 sont schématiquement illustrés et portent la référence 9.

Une unité de traitement et de commande constituée par un automate programmable 10 est reliée par des conducteurs électriques 12 aux moyens de déplacement 9 pour transmettre les ordres de commande et déplacer ainsi l'unité 5 suivant trois directions par rapport à la carte CE. En outre, cet automate 10 est relié par des conducteurs électriques 14 à une vanne V3 placée à la sortie du réservoir R3 pour contrôler la quantité du troisième constituant C qui est introduit dans l'unité de mélange 5 pour faire varier la viscosité du mélange initial A + B à sa sortie de la buse 8, suivant le type de composant à protéger au cours d'une même opération de protection de l'ensemble des composants de la carte CE.

L'automate 10 peut être également utilisé pour contrôler les quantités des deux constituants A et B introduits dans l'unité de mélange 5. A cet effet, des conducteurs électriques 15 et 16 relient l'automate à deux vannes V1 et V2 montées à la sortie des deux réservoirs R1 et R2, respectivement.

Concrètement, soit trois composants P1, P2 et P3 à protéger sur une carte électronique CE, à savoir un connecteur, un boîtier CMS de taille moyenne et un boîtier CMS de petite taille. L'automate 10 est programmé de manière à protéger ces trois composants suivant un ordre prédéterminé qui est par exemple fonction de la viscosité de l'enrobage propre à chaque type de composant- et à la protection recherchée. L'ordre choisi est par exemple P1, P2 puis P3, de manière à effectuer un enrobage du type visqueux, semi-visqueux puis fluide à partir d'un même mélange initial dont on fait varier la viscosité au fur et à mesure des déplacements de la buse d'éjection 8.

D'une manière générale, selon la viscosité désirée, on ajoute le troisième constituant C au mélange initial A + B dans les proportions en volume telles que A + B est de l'ordre de 99,9 à 90 % et C de l'ordre de 0,1 à 10 %. A titre d'exemple, la protection du connecteur P1 contre les chocs ou vibrations nécessitera un enrobage de viscosité supérieure à 70.000 mPa.s, la protection de l'humidité du boîtier CMS de taille moyenne ou composant P2 nécessitera un enrobage de viscosité comprise entre 5000 et 70.000 mPa.s, et la protection contre l'humidité du boîtier CMS de petite taille ou composant P3 nécessitera un enrobage de viscosité inférieure à 5000 mPa.s. Ces valeurs sont données pour un mélange d'un kilogramme à une température de 22°C.

L'automate 10 permet de programmer automatiquement les variations de viscosité du mélange initial dans la chambre de sortie 6 de l'unité de mélange 5 avant de l'éjecter par la buse 8 pour déposer un revêtement de protection sur chaque type de composant au cours d'une même opération.

Ainsi, en fonction du type de composant à protéger sur la carte électronique CE, on peut faire varier la viscosité de l'enrobage au fur et à mesure que la buse 6 se déplace au-dessus de la carte CE. Avantageusement, lorsque l'enrobage est déposé sous forme liquide sur un composant de la carte, on peut préalablement entourer ce composant par un cordon de revêtement visqueux pour éviter à l'enrobage de couler au-delà du composant.

Une fois que tous les composants d'une face de la carte électronique CE sont enrobés d'un revêtement protecteur, la carte CE est mise dans une étuve pour assurer la polymérisation du revêtement. Ensuite, on procède à la protection des composants éventuellement situés sur l'autre face de la carte CE après avoir retourné celle-ci. D'une manière générale, la carte CE est avantageusement protégée sur chacune de ses deux faces de manière à être entièrement enrobée d'un revêtement de protection. Pour protéger chaque bord d'extrémité de la carte ou champ de la carte, on peut déposer un cordon de protection sur la périphérie d'une face de la carte avec une viscosité telle que le cordon puisse déborder ou s'affaisser pour recouvrir le champ de la carte.

## Revendications

1. Procédé pour déposer un revêtement de protection sur les composants d'une carte électronique, le revêtement étant constitué par un matériau polymérisable tel qu'une résine, caractérisé en ce qu'il consiste à préparer le matériau constituant le revêtement à partir d'un mélange initial d'au moins deux constituants (A, B), et à ajouter à ce mélange initial au moins un troisième constituant (C) en quantité variable de manière à faire varier la viscosité du mélange initial suivant le type de composant à protéger pendant l'opération d'enrobage des composants de la carte électronique.

2. Procédé selon la revendication 1, caractérisé en ce qu'il consiste à prendre un isocyanate pour premier constituant (A) du mélange initial.

3. Procédé selon la revendication 2, caractérisé en ce que l'isocyanate est du type toluène diisocyanate ou du type diphénylméthanediisocyanate-4,4'.

4. Procédé selon l'une quelconque des revendications 1 à 3, caractérisé en ce qu'il consiste à prendre un polyol pour second constituant (B) du mélange initial.

5. Procédé selon la revendication 4, caractérisé en ce que le polyol est du type polyéther-polyol ou du type polyester-polyol.

6. Procédé selon l'une quelconque des revendications précédentes, caractérisé en ce qu'il consiste à prendre un agent thyxotropant comme troisième constituant (C) pour faire varier la viscosité du mélange initial.

7. Procédé selon la revendication 6, caractérisé en ce que l'agent thyxotropant est une 2,4 bis (p-aminobenzyl) aniline.

8. Procédé selon l'une quelconque des revendications 1 à 7, caractérisé en ce qu'il consiste à prendre un catalyseur comme troisième constituant (C) pour faire varier la viscosité du mélange initial.

9. Procédé selon la revendication 8, caractérisé en ce que le catalyseur est un composé organométallique tel qu'un dilaurate de dibutylétain.

10. Procédé selon l'une quelconque des revendications précédentes, caractérisé en ce qu'il consiste à réaliser le mélange initial à l'intérieur d'une unité de mélange (5) équipée d'une buse d'éjection (8), et en ce qu'il consiste à ajouter le troisième constituant (C) au mélange initial dans une chambre de sortie (6) de l'unité de mélange (5) qui est en communication avec la buse (8), le revêtement de protection étant ensuite éjecté de la buse (8) pour être déposé d'une manière sélective sur les différents composants suivant la viscosité requise pour chaque type de composant de la carte, en déplaçant la buse (8) par rapport à la carte ou inversement.

## Claims

1. Method for applying a protective coating to the components on a printed circuit board, said coating being comprised of a polymerizable material such as a resin, characterized in that it consists in preparing the materiel of which the coating is composed from an initial mixture of at least two ingredients (A, B) and adding to this initial mixture at least one third ingredient (c) in a variable quantity in order to vary the viscosity of the initial mixture according to the type of component to be protected during the coating of the printed circuit board components.

2. Method according to claim 1, characterized in that it consists in using an isocyanate as the first ingredient (A) of the initial mixture.

3. Method according to claim 2, characterized in that the isocyanate is of the toluene diisocyanate type or the diphenylmethane-4,4-diisocyanate type.

4. Method according to any of claims 1 to 3, characterized in that it consists in using a polyol as the second ingredient (B) of the initial mixture.

5. Method according to claims 4, characterized in that the polyol is of the polyether-polyol or polyester-polyol type.

6. Method according to any of the foregoing claims, characterized in that it consists in using a thixotropic agent as the third ingredient (C) to vary the viscosity of the initial mixture.

7. Method according to claim 6, characterized in that the thixotropic agent is a 2,4-bis (p-aminobenzyl) aniline.

8. Method according to any of claims 1 to 7, characterized in that it consists in using a catalyst as the third ingredient (C) to vary the viscosity of the initial mixture.

9. Method according to claim 8, characterized in that the catalyst is an organometallic compound such as a butyltin dilaurate.

10. Method according to any of the foregoing claims, characterized in that it consists in producing the initial mixture in a mixing unit (5) equipped with an ejection nozzle (8) and consists in adding the third 5 ingredient (c) to the initial mixture in an output chamber (6) of mixing unit (5) communicates with nozzle (8), the protective coating then being ejected from nozzle (8) and being applied selectively to the various components, depending on the viscosity required for each type of board component, by displacing nozzle (8) relative to the board or vice versa.

## Patentansprüche

1. Verfahren zur Anbringung einer Schutzschicht aus einem polymerisierbaren Material wie Harz auf den Bauteilen einer Leiterplatte, dadurch gekennzeichnet, dass es das die Schicht bildende Material aus einer Ausgangsmischung aus mindestens zwei Bestandteilen (A, B) vorbereitet und zu dieser Ausgangsmischung mindestens einen dritten Bestandteil (C) in variabler Menge hinzufügt, so dass die Viskosität der Ausgangsmischung je nach zu schützendem Bauteiltyp während des Überzugsverfahrens der Bauteile der Leiterplatte verändert wird.

2. Verfahren nach Anspruch 1, dadurch gekennzeichnet, dass die Ausgangsmischung aus einem ersten Bestandteil (A) wie Isocyanat gebildet wird.

3. Verfahren nach Anspruch 2, dadurch gekennzeichnet, dass das Isocyanat ein Methylbenzen oder Benzylbenzendiisocyanat-4.4' ist.

4. Verfahren nach irgendeinem der Ansprüche 1 bis 3, dadurch gekennzeichnet, dass die Ausgangsmischung aus einem zweiten Bestandteil (B) wie Polyol gebildet wird.

5. Verfahren nach Anspruch 4, dadurch gekennzeichnet, dass das Polyol ein Polyether-Polyol oder Polyester-Polyol ist.

6. Verfahren nach einem der oben angeführten Ansprüche, dadurch gekennzeichnet, dass die Ausgangsmischung aus einem dritten Bestandteil (C) wie thyxotropaner Stoff gebildet wird, durch den die Viskosität der Ausgangsmischung verändert wird.

7. Verfahren nach Anspruch 6, dadurch gekennzeichnet, dass der thyxotropane Stoff ein 2,4 bi (p-aminobenzyl) Anilin ist.

8. Verfahren nach irgendeinem der Ansprüche 1 bis 7, dadurch gekennzeichnet, dass die Ausgangsmischung aus einem dritten Bestandteil (C) wie Katalysator gebildet wird, durch den die Viskosität der Ausgangsmischung verändert wird.

9. Verfahren nach Anspruch 8, dadurch gekennzeichnet, dass der Katalysator eine metallorganische Verbindung wie ein Dilaurat aus Dibutylzinn ist.

10. Verfahren nach einem der oben angeführten Ansprüche, dadurch gekennzeichnet, dass es darin besteht, die Ausgangsmischung im Inneren einer Mischungseinheit (5) mit einer Ejektordüse (8) herzustellen, und dass der dritte Bestandteil (C) in einer mit der Ejektordüse (8) verbundenen Ausgangskammer (6) der Mischungseinheit (5) der Ausgangsmischung hinzugefügt und die Schutzschicht anschließend aus der Düse (8) ausgestoßen wird, um auf selektive Weise durch Verschiebung der Düse (8) auf der Platte oder umgekehrt auf den verschiedenen Bauteilen je nach benötigter Viskosität für jeden Bauteiltyp der Platte aufgetragen zu werden.
